Europäisches Patentamt

European Patent Office

Office européen des brevets

(19)

(11) Publication number: **0 452 495 A1**

# EUROPEAN PATENT APPLICATION
## published in accordance with Art. 158(3) EPC

(21) Application number: 90910925.8

(22) Date of filing: 16.07.90

(86) International application number:
PCT/JP90/00917

(87) International publication number:
WO 91/02379 (21.02.91 91/05)

(51) Int. Cl.5: **H01L 29/784**

(30) Priority: 27.07.89 JP 194749/89
27.07.89 JP 194750/89

(43) Date of publication of application:
23.10.91 Bulletin 91/43

(84) Designated Contracting States:
DE FR GB NL

(71) Applicant: SEIKO INSTRUMENTS INC.
31-1, Kameido 6-chome Koto-ku
Tokyo 136(JP)

(72) Inventor: SAITO, Naoto Seiko Instruments Inc.
31-1, Kameido 6-chome Koto-ku
Tokyo 136(JP)

(74) Representative: Fleuchaus, Leo, Dipl.-Ing. et al
Melchiorstrasse 42
W-8000 München 71(DE)

(54) MISFET AND METHOD OF PRODUCING THE SAME.

(57) A MISFET of a structure in which each of the source and the drain has a low-concentration region and a high-concentration region and a method of producing the same. In a MOS transistor having an LDD (lightly doped drain) structure, the gate is expanded up to the upper portion of the low-concentration region of each of the source and drain. This makes it possible to prevent the drain resistance from fluctuating by the generation of hot electrons.

FIG. 1(I)

## FIELD OF THE INVENTION

The present invention relates to a MISFET wherein each source and drain regions has a low-concentration region and a high-concentration region and the method of making it.

The present invention provides a high-speed MIS transistor having an LDD (Lightly Doped Drain) structure wherein a gate is prolonged directly above the low-concentration regions of source and drain regions in order to prevent change in the drain resistance and the method of producing it.

## BACKGROUND OF THE INVENTION

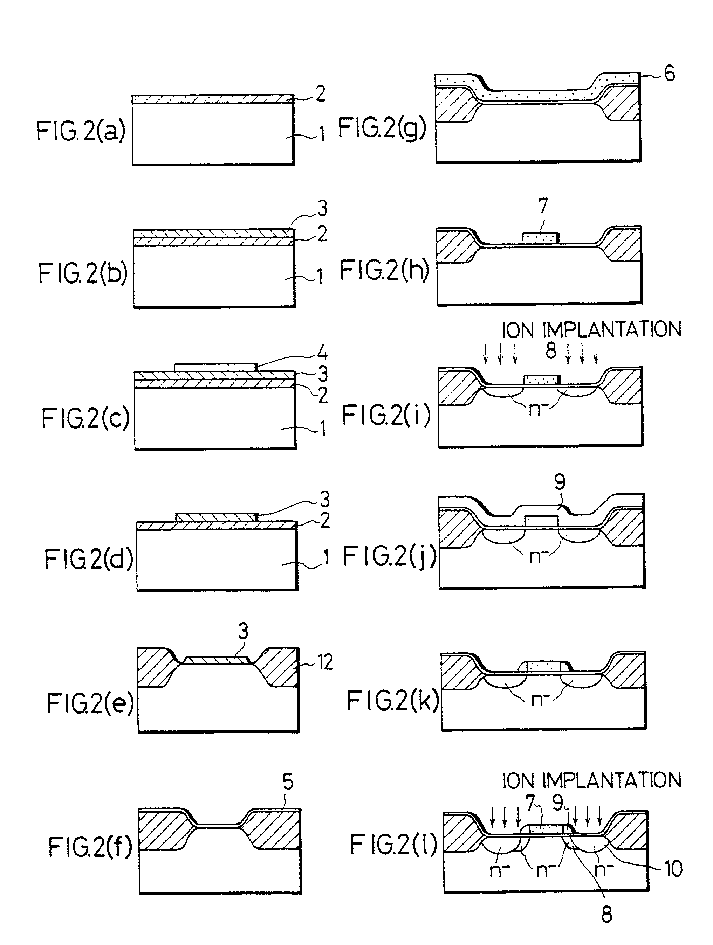

In a conventional method of producing a MISFET wherein each of source and drain regions has a low-concentration region and a high-concentration region, as in Fig. 2(a), a $SiO_2$ film 2 which is an oxide film is produced on a semiconductor substrate 1, and a SiN film 3 is formed on the $SiO_2$ film 2 (Fig. 2(b)). A resist 4 is formed, and patterning is carried out, and the SiN film 3 is etched, and then the resist 4 is removed (Figs. 2(c) and 2(d)). A localized oxidation film 12 is formed by LOCOS method (Fig. 2(e)). Further, the SiN film 3 is removed, and a gate oxide film 5 is formed (Fig.2(f)). A poly-Si film 6 is deposited, and patterning is carried out to form a poly-Si film gate 7 (Figs. 2(g) and (h)), and then a low-concentration regions of n- layer 8 is formed in the semiconductor substrate 1 by ion implantation (Fig. 2(i)). Thereafter, a $SiO_2$ film 9 is provided on and around the gate (Fig.2(j)), and etching is carried out so that the $SiO_2$ film 9 remains only around the gate over parts of the source region and the drain region (Fig. 2(k)), and then ion implantation is carried out again to form a high-concentration region of n + layer 10.

Accordingly, as shown in Fig. 2(l), although the $SiO_2$ film 9 exists over the low-concentration regions 8 of the source region and the drain region, the gate electrode 7 does not exist there.

The conventional structure involves the disadvantage that, if the transistor is continually driven in the saturated region for a predetermined time, hot electrons which cause the drain region to be depleted are generated and injected into the gate insulating film 5 directly above the drain region, and the drain resistance increases rapidly and changes (n- resistance modulation effect), and the method wherein a gate is provided directly above a low-concentration region by oblique ion implantation has difficulty in controlling the impurity profile in the surface region.

An object of the present invention is to provide a MISFET which can prevent a change in the drain resistance and the method of producing it.

## DISCLOSURE OF THE INVENTION

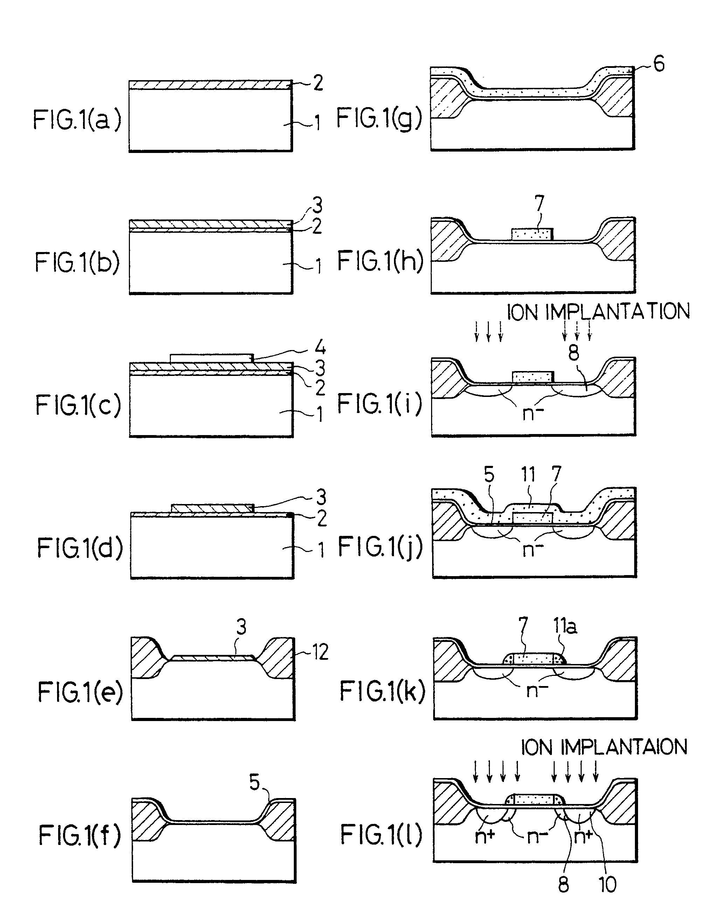

To solve the above noted problem, the present invention provides a structure wherein a gate electrode is provided directly above the low-concentration regions of the source and drain regions through a gate insulating film, as shown in Fig.1.

The above described structure enables prevention of a change in the drain resistance due to the generation of hot electrons.

## BRIEF DESCRIPTION OF THE DRAWINGS

Figs. 1(a)-1(l) are a step sequence diagram showing a first embodiment of the method for producing a MOS transistor having an LDD structure according to the present invention;

Figs. 2(a)-2(l) are a step sequence diagram showing the conventional method for producing a MOS transistor having an LDD structure;

Figs. 3(a)-3(l) are a step sequence diagram showing a second embodiment of the method for producing a MOS transistor having an LDD structure according to the present invention;

Fig. 4 is a diagram showing a state in which electrons are trapped in a gate insulating film in the MOS transistor shown in Fig. 2.

## THE BEST MODE FOR CARRYING OUT THE INVENTION

Hereinafter, embodiments of the present invention are described with reference to the drawings.

[FIRST EMBODIMENT]

The embodiment below describes a MOS transistor for example. However, the embodiment can also be applied to a MIS transistor as a matter of course.

First, in the Fig. 1(a) step, a $SiO_2$ film 2 which is an oxide film is formed on a semiconductor substrate 1. Then, a SiN film 3 is formed thereon (Fig. 1(b)). Next, a resist 4 is patterned by use of a photolithography process (Fig. 1(c)), and the SiN film 3 is etched (Fig. 1(d)). Thereafter, the silicon substrate is oxidized by LOCOS method to form a localized oxidation film 12 at portions with no SiN film (Fig. 1(e)). After the SiN film 3 has been removed, a gate oxide film 5 is formed (Fig. 1(f)). Poly-Si film 6 is predeposited thereon by low-pressure CVD (Fig. 1(g)). Then, the poly-Si film 6 is subjected to a photolithography process and etching to produce a poly-Si gate 7 (Fig. 1(h)). Next, ion implantation is carried out with using the Poly-Si gate 7 as a mask, to thereby form a low-concentration region of n- layer 8 (Fig. 1(i)). Further, poly-Si is deposited over the gate again so as to predeposit a second poly-Si film 11 (Fig. 1(j)), and thereafter anisotropic etching operation is conducted until the gate oxide film 5 is exposed so that the poly-Si film 11 having sloping faces remain only around the gate 7 (Fig. 1(k)). Ion implantation is carried out again to form a high-concentration region of n+ layer 10 (Fig. 1(l)). Carrying out the steps shown in Figs.1(j) and 1(k) enables production of a MOS transistor having an LDD structure wherein the gate is provided directly above the low-concentration region of n- layer 8.

[SECOND EMBODIMENT]

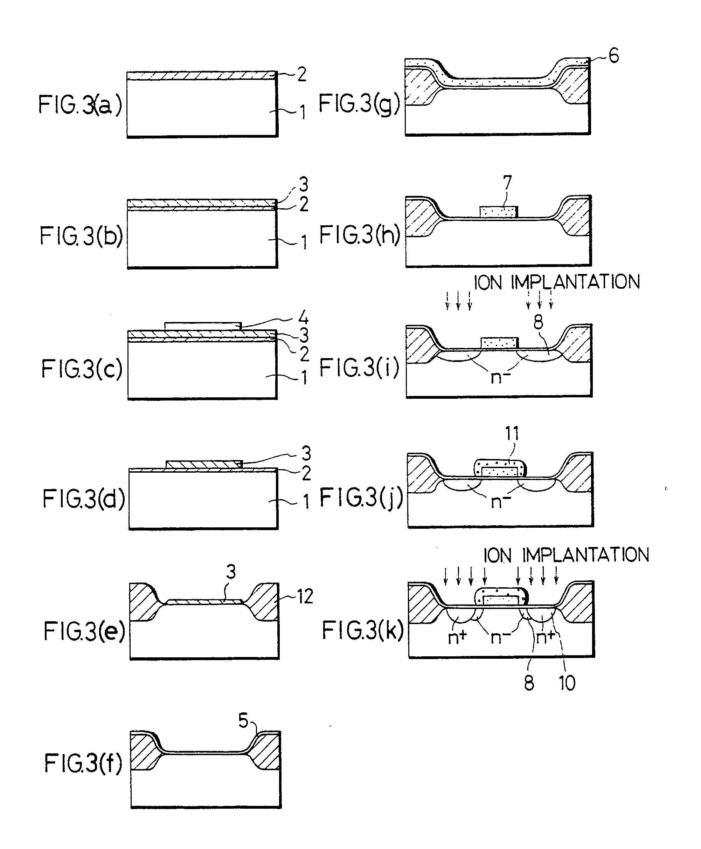

First, in the Fig. 3(a) step, a SiO$_2$ film 2 which is an oxide film is formed on a semiconductor substrate 1. Then, a SiN film 3 is formed thereon (Fig. 3(b)). Next, a resist 4 is patterned by use of a photolithography process (Fig. 3(c)), and the SiN film 3 is etched (Fig. 3(d)). Thereafter, oxidation of the silicon substrate is carried out by LOCOS method to form a localized oxidation film 12 at portions with no SiN film (Fig. 3(e)). After the SiN film 3 has been removed, a gate oxide film 5 is formed thereon (Fig. 3(f)). Poly-Si film 6 is predeposited thereon by depositing ply-Si by low-pressure CVD (Fig. 3(g)). Then, the poly-Si film 6 is subjected to a photolithography process and etching to produce a poly-Si gate 7 (Fig. 3(h)). Next, ion implantation is carried out using the poly-Si gate 7 as a mask, to thereby form a low-concentration region of n- layer 8 (Fig. 3(i)). Further, a poly-Si layer 11 is selectively deposited around the gate (Fig. 3 (j)), and thereafter, ion implantation is carried out again to form a high-concentration region of n+ layer 10 (Fig. 3(k)). MLE (Molecular Layer Epitaxy) is effective to deposit the poly-Si layer 11 selectively. The film thickness can be controlled by introducing SiH$_2$Cl$_2$ (1 x 10$^{-4}$ torr~7 x 10$^{-4}$torr) and H$_2$ alternately under the substrate temperature of 800$^\circ$C - 900$^\circ$C. By carrying out the steps shown in figs. 3(j) and 3(k), the gate is provided directly above the low-concentration region of n- layer 8, thus enabling production of a MOS transistor having an LDD structure wherein the channel length and the length of an offset region can be controlled by the film thickness of the poly-Si layer 11 which is selectively deposited.

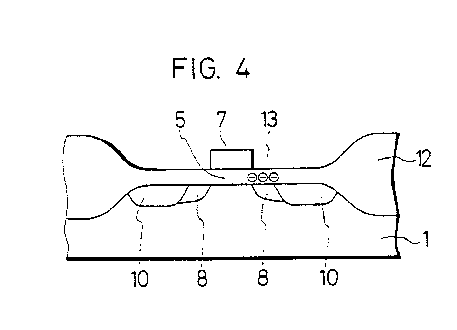

In the conventional structure shown in Fig. 2, the resistance of the low-concentration drain region 8 is not very high when no hot electrons are injected into the gate insulating film 6 (SiO$_2$ film) formed on the low-concentration drain region 8 (n-region). However, when the MOSFET having the LDD structure is continuously driven for a predetermined time, hot electrons are injected into the SiO$_2$ film (Fig. 4). Since this electric charge causes the n-layer to be completely depleted, the resistance of the n-layer insreases rapidly. Fig. 4 shows the electrons trapped in the gate insulating film formed on the n- drain region. Since the low-concentration drain region 8 is located outside the gate electrode 7, electrons are readily trapped, and as the number of the electrons increases, the n- region is depleted more and the resistance of the n- region increases. Accordingly, in the present invention shown in Fig. 1 and Fig. 3, the polysilicon gate electrode 7 is provided directly above the low-concentration drain region 8, thereby eliminating the generation of electrons trapped in the gate insulating film 6, and thus enabling prevention of change in the drain resistance.

The above noted embodiments describe a MOS transistor for example. However, the gate oxide film can be replaced with a Si$_3$N$_4$ film, Ta$_2$O$_5$ film and a multilayer-insulating film, so the present invention does not have to be limited to a MOS transistor. Al, single crystal Si, TiSi$_2$, metal with high temperature melting point (W-Mo) and silicide having metal with high temperature melting point (MoSi$_2$, WSi$_2$, TaSi$_2$) can be used as the gate electrode instead of poly-Si. In the steps of forming and expanding the gate electrode, evaporation method and sputtering method can be used instead of CVD. Further, in the step of expanding the gate electrode, patterning with a mask is also appropriate. In the step of forming the high-concentration region, MLD method can be used instead of ion-doping.

For reference, the detailed description of the MLD method can be found in the Japanese patent application No.89-194686.

**Claims**

1. A method of producing a MISFET having a structure wherein each of source and drain regions has a low-concentration region and a high-concentration region comprising the steps of:

    forming the low-concentration regions using a gate electrode as a mask;

    expanding a gate electrode to the low-concentration regions; and

    forming the high-concentration regions using the gate electrode produced in the second step as a mask.

2. A method according to claim 1; wherein the gate electrode is made of polysilicon or aluminum.

3. A method according to claim 1; wherein the expanded part of the gate electrode is made of the same material as the original part of the gate electrode.

4. A method according to claim 1; wherein the expanded part of the gate electrode is formed by depositing the predetermined material around the gate electrode and successively providing antisotropic etching.

5. A method according to claim 4; wherein the layer of the deposited predetermined material is formed around the gate electrode by low-pressure CVD.:

6. A method according to claim 1; wherein the expanded part of the gate electrode is formed by MLE.

7. A MISFET wherein a gate electrode is provided between source and drain regions through a gate insulating film and a semiconductor layer directly below the gate electrode has an opposite conductivity type to that of the source and drain regions, charecterized in that each of the source and drain regions comprises a low-concentration region and a high-concentration region, and the gate electrode is provided directly above the low-concentration regions of the source and drain regions through the gate insulating film.

8. A MISFET according to claim 7; wherein the gate electrode is made of polysilicon.

9. A MISFET according to claim 7; wherein the gate electrode above the low-concentration regions of the source and drain regions is made of a layer deposited by low-pressure CVD.

10. A MISFET according to claim 7 or 9; wherein the gate electrode above the low-concentration regions of the source and drain regions has a sloping surface.

11. A MISFET according to claim 7; wherein the gate electrode above the low-concentration regions of the source and drain regions is made of a layer deposited by MLE.

FIG.1(a)

FIG.1(b)

FIG.1(c)

FIG.1(d)

FIG.1(e)

FIG.1(f)

FIG.1(g)

FIG.1(h)

ION IMPLANTATION

FIG.1(i)

FIG.1(j)

FIG.1(k)

ION IMPLANTAION

FIG.1(l)

FIG.2(a)

FIG.2(b)

FIG.2(c)

FIG.2(d)

FIG.2(e)

FIG.2(f)

FIG.2(g)

FIG.2(h)

FIG.2(i)

ION IMPLANTATION

FIG.2(j)

FIG.2(k)

FIG.2(l)

ION IMPLANTATION

FIG.3(a)

FIG.3(b)

FIG.3(c)

FIG.3(d)

FIG.3(e)

FIG.3(f)

FIG.3(g)

FIG.3(h)

ION IMPLANTATION

FIG.3(i)

$n^-$

FIG.3(j)

$n^-$

ION IMPLANTATION

FIG.3(k)

$n^+$    $n^-$    $n^+$

FIG. 4

# INTERNATIONAL SEARCH REPORT

International Application No  PCT/JP90/00917

**I. CLASSIFICATION OF SUBJECT MATTER** (if several classification symbols apply, indicate all) 6

According to International Patent Classification (IPC) or to both National Classification and IPC

Int. Cl$^5$     H01L29/784

**II. FIELDS SEARCHED**

| Minimum Documentation Searched 7 | |
|---|---|
| Classification System | Classification Symbols |
| IPC | H01L29/784 |

| Documentation Searched other than Minimum Documentation to the Extent that such Documents are Included in the Fields Searched 8 | |
|---|---|
| Jitsuyo Shinan Koho | 1965 - 1990 |
| Kokai Jitsuyo Shinan Koho | 1971 - 1990 |

**III. DOCUMENTS CONSIDERED TO BE RELEVANT** 9

| Category * | Citation of Document, 11 with indication, where appropriate, of the relevant passages 12 | Relevant to Claim No. 13 |
|---|---|---|
| X | JP, A, 63-217664 (Fujitsu Ltd.), 9 September 1988 (09. 09. 88), (Family: none) | 1 - 11 |
| X | JP, A, 63-168050 (Hitachi, Ltd.), 12 July 1988 (12. 07. 88), Fig. 4 (Family: none) | 1 - 11 |
| Y | JP, A, 63-275181 (NEC Corp.), 11 November 1988 (11. 11. 88), (Family: none) | 1, 2, 7, 8 |
| Y | JP, A, 63-244884 (Toshiba Corp.), 12 October 1988 (12. 10. 88), (Family: none) | 1, 2, 7, 8 |

\* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure. use. exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| September 26, 1990 (26. 09. 90) | October 15, 1990 (15. 10. 90) |
| International Searching Authority | Signature of Authorized Officer |
| Japanese Patent Office | |

Form PCT/ISA/210 (second sheet) (January 1985)